# EUROPEAN PATENT SPECIFICATION

(11) **EP 4 504 813 B1**
(45) Date of publication and mention of the grant of the patent: **11.02.2026**
(21) Application number: 23718179.7
(22) Date of filing: 04.04.2023
(51) Int. Cl.: C08G 18/10, C08G 18/22, C08G 18/42, C08G 18/62, C08G 18/67, C08G 18/73, C09D 175/16

(54) **SINGLE COMPONENT UV CURABLE CONFORMAL COATING WITH MOISTURE SECONDARY CURE FUNCTION**
UV-HÄRTBARE EINKOMPONENTEN-KONFORME BESCHICHTUNG MIT FEUCHTIGKEITSSEKUNDÄRHÄRTUNGSFUNKTION
REVÊTEMENT CONFORME DURCISSABLE AUX UV À UN SEUL COMPOSANT AYANT UNE FONCTION DE DURCISSEMENT SECONDAIRE À L'HUMIDITÉ

(30) Priority: 04.04.2022 GB 202204917
(43) Date of publication of application: 12.02.2025
(60) Divisional application: 25218289.4
(73) Proprietor: H. K. Wentworth Limited, Sheerwater, Surrey GU21 5RW (GB)
(72) Inventor: KINNER, Phillip James, Surrey GU21 5RW (GB); DUFFY, Andrea, Surrey GU21 5RW (GB)
(74) Representative: Novagraaf Group
(86) International application number: PCT/EP2023/025154
(87) International publication number: WO 2023/193952

(56) References cited:
- EP-B1- 2 945 974
- CN-A- 109 321 125
- CN-A- 114 163 974

## Description

The present invention relates to a conformal coating composition, a method for conformal coating of a substrate using the composition and a substrate coated with the composition.

Conformal coating material is a thin polymeric film which conforms to the contours of a printed circuit board to protect the board's components. Typically applied at 25 to 250 µm thickness, it is applied to electronic circuitry to protect against moisture, dust, chemicals, and temperature extremes.

Coatings can be applied in a number of ways, including brushing, spraying, dispensing and dip coating. Furthermore, a number of materials can be used as a conformal coating, such as acrylics, silicones, polyurethanes and parylenes. Polyurethane coatings are a popular choice for conformal coatings due to their high chemical resistance, flexibility, and hardness.

Coatings curable by actinic radiation (e.g., "UV coatings") find use as conformal coatings as such coatings may be cured relatively quickly by exposure to a radiation source, typically UV, including traditional UV (arc and microwave types) and UV-LED light sources. The fast cure allows manufacturers to increase throughput. However, because circuit boards and other electronic components have highly contoured surfaces, such UV coatings, when used as conformal coatings, suffer from a phenomenon whereby areas of the coating which cannot easily be exposed to UV light due to the contours (i.e., the "shadow" areas) remain uncured.

US 4,424,252 describes the problem of "shadow cure" and solves such problem using dual cure resins. Such resins cure by two mechanisms: a) exposure to UV light and b) curing by atmospheric moisture. The atmospheric moisture reacts with free isocyanate groups in the dual cure resin forming an amine group(s). The amine groups react with other isocyanate groups to form a polyurea. The curing by atmospheric moisture allows the areas of the coatings in the "shadows" to fully cure.

However, dual-cure polyurethane resins have suffered a disadvantage due to their relatively high viscosity. This issue is especially relevant for conformal coatings, due to the contoured shape of the substrate. Low viscosity resins are more favoured from a flowability standpoint, i.e., the low viscosity resins more easily flow around the contours of a circuit board and may more evenly coat such circuit boards.

Previous attempts to lower the viscosity of dual-cure polyurethane resins included adding a significant amount of reactive diluent to the dual-cure polyurethane resins. While the addition of reactive diluents served to lower the viscosity of the resin, it also reduced the wt. % of free isocyanate groups in the resin. This, in turn, has the effect of reducing the effectiveness of the moisture cure mechanism especially in shadow areas, which results in a coating with insufficient hardness and/or solvent resistance in such areas.

US 9,932,492 describes one-component, dual-cure conformal coating compositions containing an isocyanate-functional urethane acrylate and a polyisocyanate containing allophanate and/or uretdione groups. The compositions are described as providing coatings with high hardness and solvent resistance. Conformal coating compositions are also disclosed in US2014/199491A1, CN109321125A, CN111548726A and CN111471337A.

Thus far, conventional conformal coating compositions exhibit an unfavourable change in their properties after aging at elevated temperature. This may result in the conformal coating providing inadequate protection to a circuit board or electronic component when used in a high temperature environment, due to stress cracking.

The present invention seeks to tackle at least some of the problems associated with the prior art, or at least to provide a commercially acceptable alternative solution thereto. Further, this invention discloses the construction/fabrication of new assemblies, devices and components using the disclosed materials and processes.

In a first aspect, the present invention provides a UV and moisture curable conformal coating composition comprising:
from 25 to 65 wt.% isocyanate functional acrylated polyurethane,
from 30 to 65 wt.% acrylic monomer,
from 3.5 to 5.5 wt.% photoinitiator,
from 0.1 to 1 wt.% defoaming agent,
from 0.5 to 1.5 wt.% dehydration agent,
from 0.2 to 1.5 wt.% wetting agent, and
from 0.5 to 2.5 wt.% coupling agent, wherein the coupling agent comprises an acrylate functional silane and/or methacrylate functional silane.

Each aspect or embodiment as defined herein may be combined with any other aspect(s) or embodiment(s) unless clearly indicated to the contrary. In particular, any features indicated as being preferred or advantageous may be combined with any other feature indicated as being preferred or advantageous.

The inventors have surprisingly found that in comparison to conventional conformal coating compositions the composition of the present invention exhibit improved retention of properties during thermal ageing testing at 130 °C. Advantageously, this may result in improved thermal shock resistance compared with existing technology. Without being bound by theory, it is considered that this is due to the combination of the acrylated polyurethane, acrylic monomer, and photoinitiator in the recited amounts.

The composition may result in the formation of a conformal coating exhibiting a favourably low glass transition temperature (T_{g}) and a favourably high elasticity (low modulus). This may be particularly suitable for protecting a circuit board during use. Without being bound by theory, it is considered that this is due to the combination of the acrylated polyurethane and acrylic monomer in the recited amounts.

Advantageously, in comparison to conventional conformal coating compositions, the composition of the present invention may undergo a slower and more controlled polymerisation process during UV curing. This may result in reduced levels of internal stress, and therefore an improved ability to withstand stress-cracking during thermal shock excursions. However, the curing may still be fast enough for use in conventional conformal coating production methods and assembly lines. Without being bound by theory, it is considered that this is due to the combination of the acrylated polyurethane, acrylic monomer, and photoinitiator in the recited amounts.

The term "conformal coating composition" as used herein may encompass a composition for forming a conformal coating, for example on a circuit board.

The composition comprises isocyanate functional acrylated polyurethane (acrylated polyurethane comprising isocyanate functional groups). The term "polyurethane" as used herein may encompass a class of polymers composed of organic units joined by carbamate (urethane) links. The term "acrylated polyurethane" as used herein may encompass a polyurethane comprising acrylate functional groups in addition to the free isocyanate functionality. The acrylate functional groups may also comprise methacrylate functional groups. The isocyanate functional acrylated polyurethane is preferably in the form of an oligomer.

The composition is both UV curable and moisture curable. The composition contains a secondary moisture curing functionality to ensure curing in areas shadowed from exposure to actinic radiation. On exposure to actinic radiation (typically UV), the photoinitiator may cause reaction between acrylate functional groups on the acrylated polyurethane and the acrylic monomer. On exposure to moisture (typically the moisture contained in air), the isocyanate functional groups may form amine groups, which in turn may react with other isocyanate groups to form a polyurea.

The composition comprises from 0.1 to 1.0 wt.% defoaming agent. The presence of the defoaming agent in the recited amount may inhibit the generation of bubbles during storage and/or use.

The composition comprises from 0.5 to 1.5 wt.% dehydration agent. The presence of the dehydration agent in the recited amount may inhibit undesirable moisture curing of the composition in storage.

The composition comprises from 0.2 to 1.5 wt.% wetting agent. The presence of the wetting agent in the recited amount may improve the ability of the composition to "wet" a substrate to which the composition is applied, e.g. a circuit board. In particular, the composition may "wet" all of the components of the circuit board.

The composition comprises from 0.5 to 2.5 wt.% coupling agent. The presence of the coupling agent in the recited amount may improve the adhesion of the final conformal coating to a substrate to which it is applied.

The composition is preferably a "single component" composition.

The composition preferably comprises from 30 to 50 wt.% isocyanate functional acrylated polyurethane, more preferably from 35 to 45 wt.% isocyanate functional acrylated polyurethane. The presence of the isocyanate functional acrylated polyurethane in such amounts may result in further improvement in the properties of retention of properties during thermal ageing, favourably low glass transition temperature, favourably high elasticity, and slower and more controlled polymerisation process during UV curing.

The isocyanate functional acrylated polyurethane is preferably a thermoplastic. The isocyanate functional acrylated polyurethane is preferably an elastomer. The isocyanate functional acrylated polyurethane is preferably an isocyanate functional acrylated thermoplastic polyurethane elastomer. This may result in a particularly favourably low glass transition temperature and/or high elasticity of a conformal coating formed by the composition.

The isocyanate functional acrylated polyurethane preferably has a ratio of acrylate functional groups to isocyanate functional groups of from 2:1 to 1:2. Such ratios may result in a particularly favourable amount of cross-linking during curing, i.e., not too little resulting in insufficient curing and not too much leading to hard, inflexible coatings.

The isocyanate functional acrylated polyurethane is preferably the reaction product of reactants comprising the following species:
at least one polyol, preferably an amorphous hydrophobic polyol;
at least one diisocyanate, preferably a branched chain diisocyanate; and
at least one hydroxyalkyl acrylate.

Typically, the diisocyanate is reacted with the polyol to give an isocyanate terminated "prepolymer", and then the prepolymer is further reacted in a second stage with the hydroxyalkyl acrylate to form the isocyanate functional acrylated polyurethane.

The polyol (preferably amorphous, hydrophobic polyol) preferably comprises:
one or more of hydroxy terminated polybutadiene, hydroxy terminated hydrogenated polybutadiene, hydroxy terminated polyisoprene, hydroxy terminated polyolefins, hydroxy terminated polyfarnesene, hydroxy terminated hydrogenated polyfarnesene, castor oil, hydrogenated castor oil, and dimer acid based polyester polyols (preferably C36), more preferably one or more of hydroxy terminated hydrogenated polybutadiene, hydroxy terminated hydrogenated polyfarnesene, hydrogenated castor oil, and dimer acid based polyester polyols; and/or
diols selected from one or more of 2-ethyl-1, 3-hexanediol, 1, 4-butanediol, 3-methyl-1, 5-pentanediol, 1, 6-hexanediol, isosorbide, C₁₈ dimer diol, 2-butyl-2-ethyl-1, 3-propanediol, 2, 2-dimethyl-1,3-propanediol and 2, 2-diethyl-1 ,3-propanediol, preferably one or more of 2-ethyl-1, 3-hexanediol, C₁₈ dimer diol and 2-butyl-2-ethyl-1, 3-propanediol; and/or
triols selected from one or more of trimethylolpropane, triethanolamine, diethanolamine, 1, 2, 6-hexanetriol, phloroglucinol (1, 3, 5-trihydroxybenzene), and glycerol, more preferably 1, 2, 6-hexanetriol.

In contrast, isocyanate functional acrylated polyurethanes of the prior art are typically formed from polyether polyols, polyester polyols, polycaprolactone polyols, polycarbonate polyols and polylactone polyols. Polyether and polyester polyols have proven, in the past, to give poor results when formulated into conformal coatings, as their electrical properties, particularly Surface Insulation Resistance (SIR), is poor in high temperature / high humidity ('harsh') environments e.g., 85% RH, 85°C, the conditions commonly used to test the conformal coatings for automotive applications. The polyether and polyester polyol based polyurethane acrylate oligomers are prone to degradation under these automotive test conditions, primarily by oxidation and hydrolysis. In addition, their low temperature performance is generally not acceptable for use in conformal coatings. Conformal coatings for automotive and aerospace applications need to remain flexible down at temperatures as low as -60°C. For the automotive industry, -40°C is the accepted standard test temperature for assessing low temperature performance. Current conformal coatings utilising polyester polyol based polyurethane acrylate oligomers do not tend to retain their mechanical properties (elongation (flexibility), tensile strength, modulus) at sub ambient temperatures, especially when they have been aged at elevated temperatures. Relatively low initial elongation values of around 50% (samples aged and tested at ambient temperatures) decrease to unacceptable levels upon heat ageing / testing at sub ambient temperatures. As observed by the inventors of the present application, elongation values of less than 50% generally translate to early failure of the conformal coating when being subjected to thermal shock testing. As the flexibility of the conformal coating is lost, extensive cracking of the coating is evident, often after only a few hundred cycles.

The glass transition temperature of the final conformal coating is also very important. Glass transition temperatures significantly higher than -40°C can also lead to stress cracking during thermal shock testing. The isocyanate functional acrylated polyurethane of the present application formed of the polyols listed above may exhibit improved properties over commercially available polyurethane acrylate oligomers (recommended for use and/or used in current radiation curable conformal coatings) because of its unique composition and low glass transition temperature. In particular, a composition containing the isocyanate functional acrylated polyurethane formed of the polyols listed above may exhibit particularly excellent flexibility and low temperature performance, along with improved SIR performance. The composition can still be cured via the primary cure mechanism (UV/UV-LED light polymerising the acrylate groups) in 'line of sight' areas and via the secondary cure mechanism (isocyanate-moisture reaction) in the 'shadow areas' of the circuit boards.

The polyol preferably has a number average molar mass of from 500 to 3000 gmol⁻¹, more preferably from 1000 to 2000 gmol⁻¹, even more preferably about 2000 gmol⁻¹.

The polyol preferably has a functionality of from 1.9 to 2.5 and/or a hydroxyl value of from 50 to 250 mg KOH/g.

The diisocyanate preferably comprises one or more of 1, 3-bis(1-isocyanato-1-methylethyl)benzene (TMXDI, tetramethylxylylene diisocyanate), 5-isocyanato-1-(isocyanatomethyl)-1, 3, 3-trimethylcyclohexane (IPDI, Isophorone diisocyanate), 1, 6-diisocyanato-2, 2, 4 (2, 4, 4)-trimethylhexane (TMDI, Trimethylhexamethylene diisocyanate), 1, 6-diisocyanatohexane (HDI, hexamethylene diisocyanate), 4, 4'-diisocyanatodicyclohexylmethane (H₁₂MDI) and 1, 5-diisocyanatopentane (PDI, 1, 5-pentamethylenediisocyanate), preferably 1, 6-diisocyanato-2, 2, 4 (2, 4, 4)-trimethylhexane (TMDI, Trimethylhexamethylene diisocyanate). This may result in the cured composition exhibiting particularly excellent flexibility and low temperature performance, along with improved SIR. Isocyanate functional acrylated polyurethanes of the prior art are typically formed from aromatic diisocyanates (e.g. TDI, toluene diisocyanate). This exacerbates the problem of poor retention of tensile properties/poor thermal shock (also due to the prior art polyol types) as the aromatic character of the resulting polymer means they are more susceptible to oxidative breakdown during ageing at elevated temperatures/humidity.

The hydroxyalkyl acrylate preferably comprises one or more of 2-hydroxyethyl acrylate, 3-hydroxypropyl acrylate, 4-hydroxybutyl acrylate, 2-hydroxyethyl methacrylate, 3-hydroxypropyl methacrylate, and 4-hydroxybutyl methacrylate, more preferably 4-hydroxybutyl acrylate. Such hydroxyalkyl acrylate have a longer carbon chain than hydroxyalkyl acrylates used to form conventional isocyanate functional acrylated polyurethane used in conformal coatings. This may result in the cured composition exhibiting particularly excellent flexibility and low temperature performance, along with improved SIR.

In a particularly preferred embodiment, the isocyanate functional acrylated polyurethane is the reaction product of reactants comprising:
one or more of hydroxy terminated hydrogenated polybutadiene, hydroxy terminated hydrogenated polyfarnesene, hydrogenated castor oil, dimer acid based polyester polyols, 2-ethyl-1, 3-hexanediol, C₁₈ dimer diol and 1, 2, 6-hexanetriol;
1, 6-diisocyanato-2, 2, 4 (2, 4, 4)-trimethylhexane (TMDI, Trimethylhexamethylene diisocyanate); and
4-hydroxybutyl acrylate.

To form the isocyanate functional acrylated polyurethane from the reaction product of the above species, a catalyst is preferably employed to increase the speed and/or selectivity of the reaction or to reduce the temperature that may be required. Suitable catalysts are known in the art, for example metal complexes and tertiary amines. Of the metal-based catalysts, organotin compounds (such as DBTL, DOTL, tin carboxylates) are very commonly used in the synthesis of polyurethanes. They offer very good performance but do have an unfavourable toxicity profile. Other metal catalysts have been developed that show similar performance/reactivity to the tin-based materials, whilst being much more user and environmentally friendly. Notable examples are compounds of zirconium, zinc and bismuth. A preferred catalyst comprises a bismuth carboxylate to catalyse the reaction of the isocyanate with the hydroxyl containing reagents. Commercial examples of such a catalyst include K-Kat XC-B221, K-Kat XK651 and K-Kat 6212 from King Industries; and Tibkat 716 and Tibkat 720 from Tib Chemicals.

The composition preferably comprises from 45 to 60 wt.% acrylic monomer, more preferably from 50 to 60 wt.% acrylic monomer. The presence of the acrylic monomer in such amounts may result in further improvement in the properties of retention of properties during thermal ageing, favourably low glass transition temperature, favourably high elasticity, and slower and more controlled polymerisation process during UV curing. The acrylic monomer may be considered to be a reactive diluent.

The acrylic monomer preferably comprises a linear alkyl acrylate comprising from 4 to 12 carbon atoms, more preferably from 6 to 12 carbon atoms, even more preferably from 8 to 10 carbon atoms. Preferably, the linear alkyl acrylate comprises octadecyl acrylate.

In addition to the linear alkyl acrylate, the acrylic monomer may preferably further comprise a diacrylate, more preferably a diacrylate selected from one or both of 1, 6-hexane diol diacrylate and 3-methyl-1,5-pentanediol diacrylate. Such species are particularly effective reactive diluents in combination with the other components of the composition.

The acrylic monomer may also comprise a cyclic acrylate, more preferably tetrahydrofurfuryl acrylate, cyclic trimethylolpropane formal acrylate, t-butylcyclohexanol acrylate, 3,3,5-trimethylcyclohexyl acrylate, isobornyl acrylate and 2-phenoxyethyl acrylate, even more preferably tetrahydrofurfuryl acrylate. Such species are particularly effective reactive diluents in combination with the other components of the composition.

The photoinitiator preferably comprises:
an alpha-hydroxy ketone-based photoinitiator, and/or
a phenylphosphine oxide-based photoinitiator, and/or
an ethyl phenylglyoxylate type photoinitiator.

More preferably, the photoinitiator comprises:
an alpha-hydroxy ketone-based photoinitiator,
a phenylphosphine oxide-based photoinitiator, and
an ethyl phenylglyoxylate type photoinitiator.

The combination of such photoinitiators may result in a particularly controlled polymerisation process during UV curing. The alpha-hydroxy ketone-based photoinitiator may result in surface cure of the composition. Commercial examples of suitable alpha-hydroxy ketone-based photoinitiators include Darocur^{™}/Irgacure 1173^{™} and Double cure^{™} 173. The phenylphosphine oxide based photoinitiator may result in through cure / deep cure of the composition. Commercial examples of suitable phenylphosphine oxide based photoinitiators include Irgacure^{™} 819 and Doublecure^{™} 1819. The methyl phenylglyoxylate type photoinitiator may be particularly effective at modifying the extent of cure to minimise internal stress during curing and prevent yellowing and excessive odour after curing. A commercial example of the methyl phenylglyoxylate type photoinitiator is Doublecure^{™} 200.

The alpha-hydroxy ketone-based photoinitiator preferably comprises 2-hydroxy-2-methyl-1-phenyl-propan-1-one. Such a photoinitiator may be particularly effective at resulting in surface curing of the composition.

The phenylphosphine oxide-based photoinitiator preferably comprises phenyl bis(2,4,6-trimethylbenzoyl)-phosphine oxide, ethyl (2,4,6-trimethylbenzoyl)phenyl phosphinate and/or diphenyl (2,4,6-trimethylbenzoyl) phosphine oxide. Such photoinitiators may be particularly effective at resulting in through cure / deep cure of the composition.

The ethyl phenylglyoxylate type photoinitiator preferably comprises methyl benzoylformate. Such a photoinitiator may be particularly effective at modifying the rate of cure to minimise internal stress during curing and prevent yellowing and excessive odour after curing.

The photoinitiator preferably comprises: a thioxanthone type initiator, preferably comprising 2-isopropylthioxanthone; and a tertiary amine synergist, preferably comprising ethyl-4-(dimethylamino)benzoate. Photoinitiator and synergist combination may be particularly effective at resulting in a good balance of surface and through (deep) cure of the composition. Commercial examples of the thioxanthone type photoinitiator and synergists are Ominrad^{™} ITX, Speedcure^{™} ITX and Omnirad^{™} EDB.

The composition preferably comprises from 3.8 to 5.2 wt.% photoinitiator, more preferably from 4 to 4.5 wt.% photoinitiator.

The defoaming agent preferably comprises a polyether siloxane. Polyether siloxane is a particularly effective defoaming agent when used in combination with the other components of the composition.

The composition preferably comprises from 0.2 to 0.8 wt.% defoaming agent, more preferably from 0.3 to 0.7 wt.% defoaming agent.

The dehydration agent preferably comprises p-toluenesulfonylisocyanate. P-toluenesulfonylisocyanate is a particularly effective dehydration agent when used in combination with the other components of the composition.

The composition preferably comprises from 0.7 to 1.3 wt.% dehydration agent, more preferably from 0.8 to 1.2 wt.% dehydration agent.

The wetting agent preferably comprises poly[dimethylsiloxane-co-methyl(3-hydroxypropyl)siloxane]-graft-poly(ethylene glycol) methyl ether. Poly[dimethylsiloxane-co-methyl(3-hydroxypropyl)siloxane]-graft-poly(ethylene glycol) methyl ether is a particularly effective wetting agent when used in combination with the other components of the composition.

The composition preferably comprises from 0.5 to 1.3 wt.% wetting agent, more preferably from 0.8 to 1.2 wt.% wetting agent.

The coupling agent comprises an acrylate functional silane and/or methacrylate functional silane. Such silanes are a particularly effective coupling agent when used in combination with the other components of the composition.

The composition preferably comprises from 1 to 2 wt.% coupling agent, more preferably from 1.0 to 1.5 wt.% coupling agent.

Traditionally, lower viscosity conformal coating compositions have been considered to flow out better over the surface of a PCB than higher viscosity alternatives. However, reducing the viscosity of a conformal coating composition may facilitate excess flow under components, which can make full secondary cure difficult.

However, the inventors have found that modification of the rheology of the conformal coating composition, rather than just modification of the viscosity, is highly beneficial. The conformal coating composition described herein preferably contains a rheology modifier.

The rheology modifier preferably comprises polyamide wax, preferably in the form of crystalline fibres (polyamide wax comprising crystalline fibers). Advantageously, the use of polyamide wax may enable the composition to be applied to a PCB by selective spray coating. This is because the polyamide wax may introduce thixotropy into the system. Thixotropy is a shear thinning characteristic which imparts low viscosity at high shear rates and high viscosity at low shear rates. Selective spray application is a high shear process which means that the coating is applied to the PCB at low viscosity, allowing good flow and full conformance to the PCB surface. Following application, where low shear conditions predominate, the coating viscosity may undergo a time dependant recovery to the initial high viscosity system. This minimises excessive flow under components and at the board edges (splashing, overspray) i.e., controlled flow. This feature may also ensure complete edge coverage of the components of the PCB. This is an issue that has caused problems for many a conventional conformal coating. Sharp edges of components / component legs are generally not coated sufficiently well using low viscosity coating compositions, leading to PCB failure because of these thin, weak areas in the conformal coating. The conformal coating composition of the present invention aims to address this. Without being bound by theory, it is considered that the crystalline fibres of the polyamide wax form an interacting network within the conformal coating composition. This network can be broken down under high shear conditions, but quickly re-establishes itself once those shear forces are removed, returning to its original state. In this regard, the composition preferably exhibits a thixotropic index of from 1.5 to 3.5. This may be achieved by the use of the polyamide wax.

The composition preferably further comprises a UV tracer. This may result in the composition advantageously glowing blue under black light.

The UV tracer preferably comprises 2,5-thiophenediylbis(5-tert-butyl-1,3-benzoxazole). 2,5-thiophenediylbis(5-tert-butyl-1,3-benzoxazole) is a particularly effective UV tracer in combination with the other components of the composition.

The composition preferably comprises from 0.1 to 0.5 wt.% UV tracer, more preferably from 0.2 to 0.4 wt.% UV tracer.

The composition preferably comprises an odour masking agent. This may render the composition more pleasant to use.

The odour masking agent preferably comprises one or both of dimethyloct-7-en-2-ol and butylcyclohexyl acetate, preferably both. Such species are particularly effective odour masking agents in combination with the other components of the composition.

In a further aspect, the present invention provides a method for conformal coating of a substrate, the method comprising:
providing a substrate,
providing the composition described herein,
depositing the composition over at least a portion of the substrate, and
exposing the coated substrate to actinic radiation.

The advantages and preferable features of the first aspect apply equally to this aspect.

Depositing the composition over at least a portion of the substrate may comprise one or more of brushing, spraying, dispensing and dip coating.

The actinic radiation preferably comprises UV, for example UV-LED.

The substrate preferably comprises a circuit board or an electronic component.

In a further aspect, the present invention provides a substrate coated with the composition described herein. The advantages and preferable features of the first aspect apply equally to this aspect.

### Examples

The invention will now be further described by reference to the following examples

### General synthesis of the isocyanate functional acrylated polyurethane oligomer:

In the first stage, the diisocyanate is reacted with the polyol (and/or diol/triol) at elevated temperature, under nitrogen, using a catalyst, to give an isocyanate terminated 'prepolymer'. This prepolymer is further reacted in a second stage with the hydroxyalkyl acrylate, under air, to form the isocyanate functional polyurethane acrylate oligomer. Elevated temperatures and a catalyst are used to decrease the total reaction time, the temperatures required for the reaction and/or to improve the selectivity of the reaction between the isocyanate groups in the diisocyanate and the hydroxyl groups of the other reactants.

An example reaction scheme is as follows:

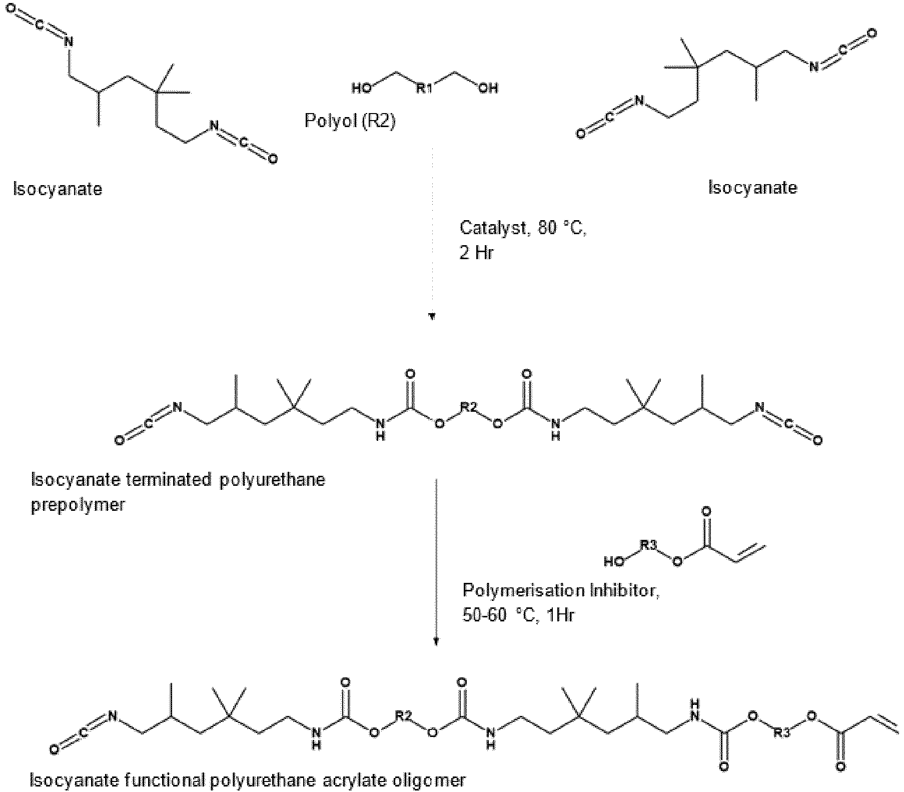

The above reaction scheme shows steps 1 and 2 and an idealised structure of the product - the isocyanate functional polyurethane acrylate oligomer.

In the reaction scheme (step 2, acrylation), the R3 group of the hydroxyalkyl acrylate can be as follows...
- CH₂CH₂- for 2-Hydroxyethyl acrylate
- CH₂CH₂CH₂- for 3-Hydroxypropyl acrylate
- CH₂CH₂CH₂CH₂- for 4-Hydroxybutyl acrylate

In the reaction scheme (step 1) the representative structures of the reagents used are as follows:

### Polyols/Diols:

### C36 Dimer acid based polyester polyol:

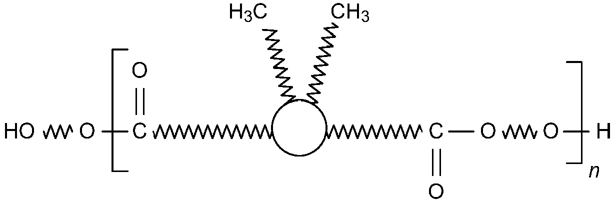

### Hydrogenated polybutadiene:

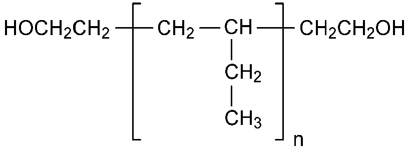

### C36 Dimer Diol:

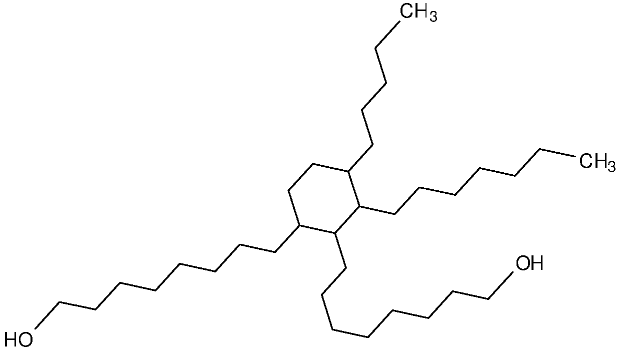

### Isocyanate:

### TMDI

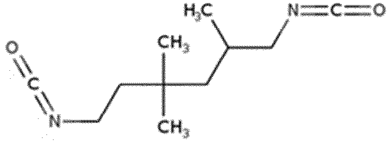

### Oligomer Synthesis - Sample 1:

2, 2, 4 (2, 4, 4)-trimethylhexamethylene diisocyanate (0.21 moles, 44.10g) and a bismuth carboxylate catalyst (0.1% by weight on total batch) were added to a round bottomed reaction flask, fitted with a thermometer, stirrer, and nitrogen line. The nitrogen was introduced to the flask as an initial purge, followed by a constant flow of approx. 1ml/min to maintain the inert atmosphere. A C₃₆ dimer acid based polyester polyol, of molar mass 2000 gmol⁻¹ (0.1 moles, 200g) was added to the flask. The reaction was run at 80°C for 2 hours, whereby an isocyanate terminated prepolymer was formed. The end point of this reaction was when the theoretical % isocyanate was achieved (measured by back titration with Di-n-butylamine, according to ISO 14896) and the FTIR spectrum showed the characteristic bands for an isocyanate terminated polyurethane prepolymer, coupled by an absence of the bands associated with hydroxyl groups. Once this stage was complete, the nitrogen line was replaced with a dry air line. Again, an initial purge was followed by application of a constant flow of approx. 1ml/min to maintain an oxygen rich atmosphere. The temperature was reduced from 80°C to 50°C, then 100ppm of polymerisation inhibitor e.g., phenothiazine, MEHQ etc. was added to the flask (to prevent self-polymerisation of the acrylate groups). Once this was dissolved/dispersed fully in the isocyanate terminated polyurethane prepolymer, 4-hydroxybutyl acrylate (0.11 moles, 15.86g) was added to the flask. This reaction was run at 50-60°C for one hour. Again, the end point of this reaction was when the theoretical % isocyanate was achieved and the FTIR spectrum showed the characteristic bands for an isocyanate terminated polyurethane prepolymer; this time, coupled by the presence of bands associated with acrylate groups. A viscous (625,000 mPa.s at 20°C), colourless, isocyanate functional urethane acrylate oligomer was obtained in high yield (>95%). Final isocyanate content was 1.78% and an acrylate: isocyanate ratio of 1:1.

### Oligomer Synthesis - Sample 2:

This polyurethane acrylate oligomer was prepared using the same process as described in Example 1. 2, 2, 4 (2, 4, 4)-trimethylhexamethylene diisocyanate (1.356 moles, 284.76g) and the bismuth carboxylate catalyst (0.1% by weight on total batch) was reacted with a C₃₆ dimer acid based polyol, of mass ~540 gmol⁻¹(0.645 moles, 349.59g), to form the isocyanate terminated prepolymer. 4-hydroxybutyl acrylate (0.71 moles, 102.41g) then added to the flask and reacted to form the polyurethane acrylate oligomer. A viscous (103,000 mPa.s at 20°C), straw coloured, isocyanate functional urethane acrylate oligomer was obtained in high yield (>95%). Final isocyanate content was 4.31% and an acrylate: isocyanate ratio of 1:1.

### Oligomer Synthesis - Sample 3:

This polyurethane acrylate oligomer was prepared using the same process as described in Example 1. 2, 2, 4 (2, 4, 4)-trimethylhexamethylene diisocyanate (0.21 moles, 44.10g) and the bismuth carboxylate catalyst (0.01% by weight on total batch) was reacted with a hydrogenated polybutadiene polyol of molar mass 2000 gmol⁻¹(0.1 moles, 200g) to form the isocyanate terminated prepolymer. 2-hydroxyethyl acrylate (0.11 moles, 12.77g) was then added to the flask and reacted to form the polyurethane acrylate oligomer. A viscous (750,000 mPa.s at 20°C), straw coloured, isocyanate functional urethane acrylate oligomer was obtained in high yield (>95%). Final isocyanate content was 1.73% and an acrylate: isocyanate ratio of 1:1.

### Testing of the isocyanate functional acrylated polyurethane oligomers:

### Surface Insulation Resistance (SIR) Improvements

This is a key property of conformal coatings and is routinely evaluated under harsh conditions, to check for (a) initial SIR values, (b) any trends in SIR values over time and (c) any evidence of corrosion etc. on the PCB. A downward trend is indicative of deterioration of the conformal coating, leading to premature failure of the PCB via corrosion, dendrite formation, tin whiskers etc.

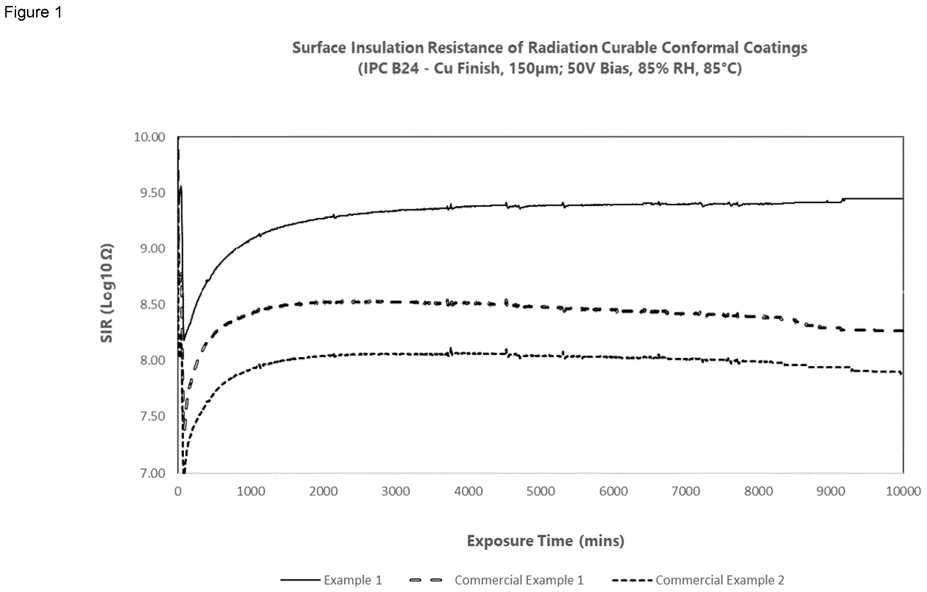

Lab tests on the oligomer Samples 1-3 suggest that a higher value for SIR can be achieved (one order of magnitude) than for commercially available oligomers. The results of the SIR testing of Sample 1 and two commercially available oligomers are shown in Figure 1. Commercial Example 1 is an isocyanate aliphatic functional urethane acrylate. Commercial Example 2 is an oligomer with UV, isocyanate and siloxane functionality. As can be seen, Sample 1 achieves an average SIR value of 9.31 with a stable, linear response over the test period, indicating the coating is performing well and not showing any signs of deterioration. Both commercial oligomers return a lower average SIR value, 8.42 and 7.98 respectively for Commercial Example 1 and Commercial Example 2. In addition, the response of these oligomers is not stable, showing a clear downward trend. The stable response of Sample 1 at 85% relative humidity and 85°C is excellent. The minimum SIR value accepted for an automotive application is a Log₁₀ of 8, which Sample 1 surpasses by some margin. Conversely, both of the commercial oligomers perform poorly in this test and would fail to meet this standard during extended testing, based on the downward trend in values over time.

### Improvement in retention of tensile properties

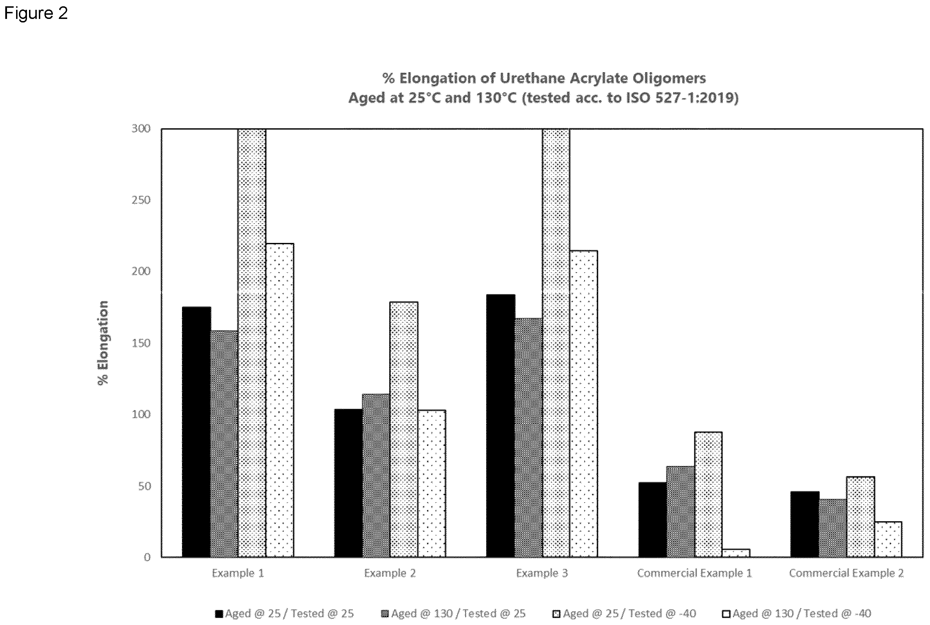

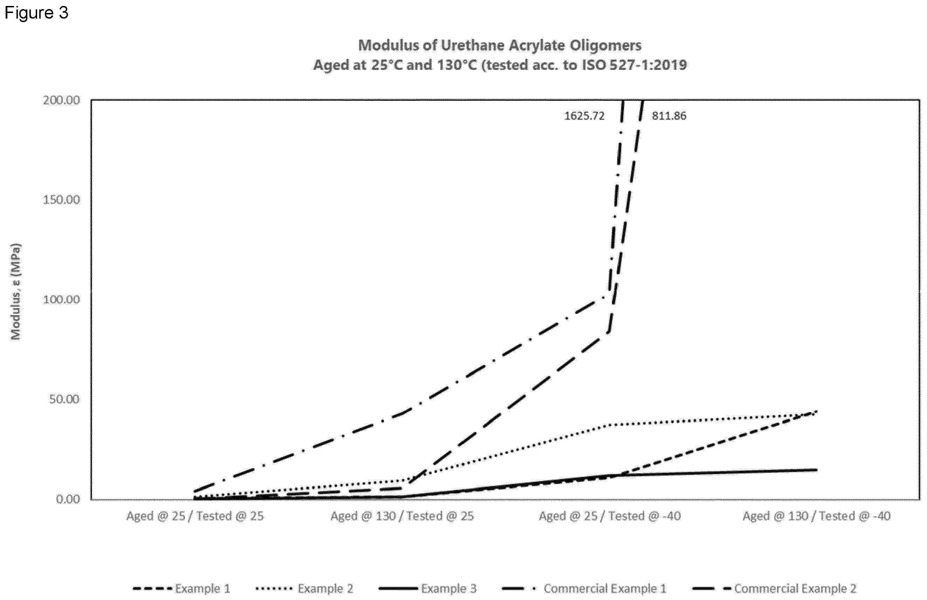

Tensile properties of the Sample 1-3 oligomers and the commercial examples were measured initially (after primary and secondary curing had taken place) and after ageing at 130°C. Testing was performed at ambient temperature and at -40°C. Sample 1 showed higher elongation and lower modulus values initially and retained a higher degree of these initial properties after ageing. The elongation and modulus values are shown in Figures 2 and 3. In terms of elongation, Samples 1, 2 and 3 show higher levels of elasticity / flexibility than both the commercial materials when tested initially. They retain their elasticity after heat ageing and when tested at sub-ambient temperatures. When these two conditions are combined, Samples 1-3 perform exceptionally well.

The Commercial Example 2 oligomer, whilst having a lower initial elongation value, does tend to fare better in terms of retention of this elongation upon heat ageing. The combination of heat ageing and sub-ambient testing does return a poor result however, with an approx. 50% drop in elongation. The Commercial Example 1 oligomer appears far inferior to Samples 1-3 in terms of retention of elasticity. Initial elongation values of around 50% drop 10 fold (to around 5%) after heat ageing and testing at sub-ambient temperatures. The test samples break almost immediately upon starting the test. Commercial Examples 1 and 2 appear to show predominantly plastic deformation when testing at sub-ambient temperatures, with no discernible recovery (return to original sample dimensions) upon returning to room temperature. Samples 1-3 appear to show predominantly elastic deformation with quick recovery (samples return to original dimensions in less than a minute at room temperature).

In terms of modulus, a measure of 'stiffness' of the sample, the higher the modulus, the stiffer and less elastic the material. All the oligomers tested started with very low moduli indicating soft, elastic materials. Upon ageing Samples 1-3 did exhibit a moderate increase in modulus values of one order of magnitude, from 0.5-1.0 to 15-45 MPa, but as noted above, this did not seem to affect the elasticity / recovery significantly.

However, both commercial materials exhibited a significant increase in modulus when testing at sub-ambient temperatures, which was exacerbated when aged at elevated temperature before testing. Two orders of magnitude increase was returned when unaged samples (stored at 25°C before testing) were tested at -40°C which increased to two orders of magnitude for the aged samples at the same test temperature.

This manifests as increased stiffness and poor recovery of these samples. Without being bound by theory, it is likely that these changes in tensile properties are due to the increased crystallinity (and associated intermolecular bonding) of the commercial materials when compared to Sample 1-3 oligomers. This would also account for the poor thermal shock performance. The above test regimes are designed to simulate what a conformal coating (in this case, oligomers) is subjected to under real use conditions.

### Improvement in Thermal Shock Resistance

Thermal shock testing indicated that Samples 1-3 exhibited improved thermal shock resistance in comparison to the commercial oligomers.

### Reduction of Tg (glass transition temperature)

Tg testing indicated that Samples 1-3 exhibited lower Tg temperatures in comparison to the commercial oligomers.

The foregoing detailed description has been provided by way of explanation and illustration and is not intended to limit the scope of the appended claims. Many variations in the presently preferred embodiments illustrated herein will be apparent to one of ordinary skill in the art, and remain within the scope of the appended claims.

## Claims

1. A UV and moisture curable conformal coating composition comprising:
from 25 to 65 wt.% isocyanate functional acrylated polyurethane,
from 30 to 65 wt.% acrylic monomer,
from 3.5 to 5.5 wt.% photoinitiator,
from 0.1 to 1 wt.% defoaming agent,
from 0.5 to 1.5 wt.% dehydration agent,
from 0.2 to 1.5 wt.% wetting agent, and
from 0.5 to 2.5 wt.% coupling agent, wherein the coupling agent comprises an acrylate functional silane and/or methacrylate functional silane.

2. The composition of claim 1, comprising from 30 to 50 wt.% isocyanate functional acrylated polyurethane, preferably from 35 to 45 wt.% of isocyanate functional acrylated polyurethane; and/or
wherein the isocyanate functional acrylated polyurethane is a thermoplastic;
and/or
wherein the isocyanate functional acrylated polyurethane is an elastomer.

3. The composition of claim 1 or claim 2, wherein the isocyanate functional acrylated polyurethane has a ratio of acrylate functional groups to isocyanate functional groups of from 2:1 to 1:2.

4. The composition of any preceding claim, wherein the isocyanate functional acrylated polyurethane is the reaction product of reactants comprising the following species:
a polyol, preferably an amorphous hydrophobic polyol;
a diisocyanate, preferably a branched chain diisocyanate; and
a hydroxyalkyl acrylate;
preferably wherein the polyol comprises:
one or more of hydroxy terminated polybutadiene, hydroxy terminated hydrogenated polybutadiene, hydroxy terminated polyisoprene, hydroxy terminated polyolefins, hydroxy terminated polyfarnesene, hydroxy terminated hydrogenated polyfarnesene, castor oil, hydrogenated castor oil, and dimer acid based polyester polyols (preferably C36), preferably one or more of hydroxy terminated hydrogenated polybutadiene, hydroxy terminated hydrogenated polyfarnesene, hydrogenated castor oil, and dimer acid based polyester polyols; and/or
diols selected from one or more of 2-ethyl-1, 3-hexanediol, 1, 4-butanediol, 3-methyl-1, 5-pentanediol, 1, 6-hexanediol, isosorbide, C₁₈ dimer diol, 2-butyl-2-ethyl-1, 3-propanediol, 2, 2-dimethyl-1, 3-propanediol and 2, 2-diethyl-1 ,3-propanediol, preferably one or more of 2-ethyl-1, 3-Hexanediol, C₁₈ dimer diol and 2-butyl-2-ethyl-1, 3-propanediol; and/or
triols selected from one or more of trimethylolpropane, triethanolamine, diethanolamine, 1, 2, 6-hexanetriol, phloroglucinol (1, 3, 5-trihydroxybenzene), and glycerol, preferably 1, 2, 6-hexanetriol.

5. The composition of claim 4, wherein the polyol has a molar mass of from 500 to 3000 gmol⁻¹, preferably from 1000 to 2000 gmol⁻¹, more preferably about 2000 gmol⁻¹; and/or
wherein the polyol has a functionality of from 1.9 to 2.5 and/or a hydroxyl value of from 50 to 250 mg KOH/g; and/or
wherein the diisocyanate comprises one or more of 1, 3-Bis(1-isocyanato-1-methylethyl)benzene (TMXDI, tetramethylxylylene diisocyanate), 5-isocyanato-1-(isocyanatomethyl)-1, 3, 3-trimethylcyclohexane (IPDI, Isophorone diisocyanate), 1, 6-diisocyanato-2, 2, 4 (2, 4, 4)-trimethylhexane (TMDI, Trimethylhexamethylene diisocyanate), 1, 6-diisocyanatohexane (HDI, hexamethylene diisocyanate), 4, 4'-diisocyanatodicyclohexylmethane (H₁₂MDI) and 1, 5-diisocyanatopentane (PDI, 1, 5-pentamethylenediisocyanate), preferably 1, 6-diisocyanato-2, 2, 4 (2, 4, 4)-trimethylhexane (TMDI, Trimethylhexamethylene diisocyanate); and/or
wherein the hydroxyalkyl acrylate comprises one or more of 2-hydroxyethyl acrylate, 3-hydroxypropyl acrylate, 4-hydroxybutyl acrylate, 2-hydroxyethyl methacrylate, 3-hydroxypropyl methacrylate, and 4-hydroxybutyl methacrylate, preferably 4-hydroxybutyl acrylate.

6. The composition of any preceding claim, comprising from 45 to 60 wt.% acrylic monomer, preferably from 50 to 60 wt.% acrylic monomer; and/or
wherein the acrylic monomer comprises
comprises a linear alkyl acrylate comprising from 4 to 12 carbon atoms, preferably from 6 to 12 carbon atoms, more preferably from 8 to 10 carbon atoms; and/or
wherein the acrylic monomer comprises
one or both of 1, 6-hexane diol diacrylate and 3-methyl-1,5-pentanediol diacrylate.

7. The composition of any preceding claim, wherein the acrylic monomer comprises a cyclic acrylate, preferably tetrahydrofurfuryl acrylate, cyclic trimethylolpropane formal acrylate, t-butylcyclohexanol acrylate, 3,3,5-trimethylcyclohexyl acrylate, isobornyl acrylate and 2-phenoxyethyl acrylate, more preferably tetrahydrofurfuryl acrylate.

8. The composition of any preceding claim, wherein the photoinitiator comprises:
an alpha-hydroxy ketone-based photoinitiator, and/or
a phenylphosphine oxide-based photoinitiator, and/or
an ethyl phenylglyoxylate type photoinitiator;
preferably wherein the photoinitiator comprises:
an alpha-hydroxy ketone-based photoinitiator,
a phenylphosphine oxide-based photoinitiator, and
an ethyl phenylglyoxylate type photoinitiator.

9. The composition of claim 8, wherein the alpha-hydroxy ketone-based photoinitiator comprises 2-hydroxy-2-methyl-1-phenyl-propan-1-one; and/or
wherein the phenylphosphine oxide-based photoinitiator comprises phenyl bis(2,4,6-trimethylbenzoyl)-phosphine oxide, ethyl (2,4,6-trimethylbenzoyl)phenyl phosphinate and/or diphenyl (2,4,6-trimethylbenzoyl) phosphine oxide; and/or
wherein the ethyl phenylglyoxylate type photoinitiator comprises methyl benzoylformate; and/or
wherein the photoinitiator comprises:
a thioxanthone type initiator, preferably comprising 2-isopropylthioxanthone; and
a tertiary amine synergist, preferably comprising ethyl-4-(dimethylamino)benzoate.

10. The composition of any preceding claim, comprising from 3.8 to 5.2 wt.% photoinitiator, preferably from 4 to 4.5 wt.% photoinitiator.

11. The composition of any preceding claim, wherein the defoaming agent comprises a polyether siloxane; and/or
comprising from 0.2 to 0.8 wt.% defoaming agent, preferably from 0.3 to 0.7 wt.% defoaming agent; and/or
wherein the dehydration agent comprises p-toluenesulfonylisocyanate; and/or
comprising from 0.7 to 1.3 wt.% dehydration agent, preferably from 0.8 to 1.2 wt.% dehydration agent; and/or
wherein the wetting agent comprises poly[dimethylsiloxane-co-methyl(3-hydroxypropyl)siloxane]-graft-poly(ethylene glycol) methyl ether; and/or
comprising from 0.5 to 1.3 wt.% wetting agent, preferably from 0.8 to 1.2 wt.% wetting agent.

12. The composition of any preceding claim, comprising 1 to 2 wt.% coupling agent, preferably from 1.3 to 1.8 wt.% coupling agent; and/or
further comprising a rheology modifier, preferably wherein the rheology modifier comprises polyamide wax and/or wherein the composition comprises from 0.1 to 2.5 wt.% rheology modifier, preferably from 0.2 to 0.8 wt.% rheology modifier, more preferably from 0.3 to 0.7 wt.% rheology modifier.

13. The composition of any preceding claim, further comprising a UV tracer, preferably wherein the UV tracer comprises 2,5-thiophenediylbis(5-tert-butyl-1,3-benzoxazole and/or the composition comprises from 0.1 to 0.5 wt.% UV tracer, preferably from 0.2 to 0.4 wt.% UV tracer; and/or
further comprising an odour masking agent; preferably wherein the odour masking agent comprises one or both of dimethyloct-7-en-2-ol and butylcyclohexylacetate, preferably both.

14. A method for conformal coating of a substrate, the method comprising:
providing a substrate, preferably wherein the substrate comprises a circuit board or an electronic component,
providing the composition of any preceding claim,
depositing the composition over at least a portion of the substrate, and
exposing the coated substrate to actinic radiation.

15. A substrate coated with the composition of any of claims 1 to 13.

## Patentansprüche

1. UV- und feuchtigkeitshärtbare konforme Beschichtungszusammensetzung, umfassend:
von zu 25 bis 65 Gew.-% Isocyanat-funktionelles acryliertes Polyurethan,
von zu 30 bis 65 Gew.-% Acrylmonomer,
von zu 3,5 bis 5,5 Gew.-% Photoinitiator,
von zu 0,1 bis 1 Gew.-% Entschäumungsmittel,
von zu 0,5 bis 1,5 Gew.-% Dehydratisierungsmittel,
von zu 0,2 bis 1,5 Gew.-% Benetzungsmittel und
von zu 0,5 bis 2,5 Gew.-% Kopplungsmittel, wobei das Kopplungsmittel ein Acrylat-funktionelles Silan und/oder Methacrylat-funktionelles Silan umfasst.

2. Zusammensetzung nach Anspruch 1, umfassend von zu 30 bis 50 Gew.-% Isocyanat-funktionelles acryliertes Polyurethan, vorzugsweise von zu 35 bis 45 Gew.-% Isocyanat-funktionelles acryliertes Polyurethan; und/oder
wobei das Isocyanat-funktionelle acrylierte Polyurethan ein Thermoplast ist; und/oder
wobei das Isocyanat-funktionelle acrylierte Polyurethan ein Elastomer ist.

3. Zusammensetzung von Anspruch 1 oder 2, wobei das Isocyanat-funktionelle acrylierte Polyurethan ein Verhältnis von Acrylat-funktionellen Gruppen zu Isocyanat-funktionellen Gruppen von 2 : 1 bis 1 : 2 aufweist.

4. Zusammensetzung nach einem der vorstehenden Ansprüche, wobei das Isocyanat-funktionelle acrylierte Polyurethan das Reaktionsprodukt von Reaktanten ist, umfassend die folgenden Spezies:
ein Polyol, vorzugsweise ein amorphes hydrophobes Polyol;
ein Diisocyanat, vorzugsweise ein verzweigtkettiges Diisocyanat; und
ein Hydroxyalkylacrylat;
vorzugsweise wobei das Polyol umfasst:
eines oder mehrere von Hydroxy-terminiertem Polybutadien, Hydroxy-terminiertem hydriertem Polybutadien, Hydroxy-terminiertem Polyisopren, Hydroxy-terminierten Polyolefinen, Hydroxy-terminiertem Polyfarnesen, Hydroxy-terminiertem hydriertem Polyfarnesen, Rizinusöl, hydriertem Rizinusöl und Polyesterpolyolen auf Dimersäure-Basis (vorzugsweise C36), vorzugsweise eines oder mehrere von Hydroxy-terminiertem hydriertem Polybutadien, Hydroxy-terminiertem hydriertem Polyfarnesen, hydriertem Rizinusöl und Polyesterpolyolen auf Dimersäure-Basis; und/oder
Diole, die aus einem oder mehreren von 2-Ethyl-1,3-hexandiol, 1,4-Butandiol, 3-Methyl-1,5-pentandiol, 1,6-Hexandiol, Isosorbid, C₁₈-Dimerdiol, 2-Butyl-2-ethyl-1,3-propandiol, 2,2-Dimethyl-1,3-propandiol und 2,2-Diethyl-1,3-propandiol, vorzugsweise einem oder mehreren von 2-Ethyl-1,3-hexandiol, C₁₈-Dimerdiol und 2-Butyl-2-ethyl-1,3-propandiol, ausgewählt sind; und/oder
Triole, die aus einem oder mehreren von Trimethylolpropan, Triethanolamin, Diethanolamin, 1,2,6-Hexantriol, Phloroglucinol (1,3,5-Trihydroxybenzol) und Glycerol, vorzugsweise 1,2,6-Hexantriol, ausgewählt sind.

5. Zusammensetzung nach Anspruch 4, wobei das Polyol eine Molmasse von 500 bis 3000 gmol⁻¹, vorzugsweise von 1000 bis 2000 gmol⁻¹, mehr bevorzugt etwa 2000 gmol⁻¹, aufweist; und/oder
wobei das Polyol eine Funktionalität von 1,9 bis 2,5 und/oder einen Hydroxylwert von 50 bis 250 mg KOH/g aufweist; und/oder
wobei das Diisocyanat eines oder mehrere von 1,3-Bis(1-isocyanato-1-methylethyl)benzol (TMXDI, Tetramethylxylylendiisocyanat), 5-Isocyanato-1-(isocyanatomethyl)-1,3,3-trimethylcyclohexan (IPDI, Isophorondiisocyanat), 1,6-Diisocyanato-2,2,4(2,4,4)-trimethylhexan (TMDI,
Trimethylhexamethylendiisocyanat), 1,6-Diisocyanatohexan (HDI, Hexamethylendiisocyanat), 4,4'-Diisocyanatodicyclohexylmethan (H₁₂MDI) und 1,5-Diisocyanatopentan (PDI, 1,5-Pentamethylendiisocyanat), vorzugsweise 1,6-Diisocyanato-2,2,4(2,4,4)-trimethylhexan (TMDI, Trimethylhexamethylendiisocyanat), umfasst; und/oder
wobei das Hydroxyalkylacrylat eines oder mehrere von 2-Hydroxyethylacrylat, 3-Hydroxypropylacrylat, 4-Hydroxybutylacrylat, 2-Hydroxyethylmethacrylat, 3-Hydroxypropylmethacrylat und 4-Hydroxybutylmethacrylat, vorzugsweise 4-Hydroxybutylacrylat, umfasst.

6. Zusammensetzung nach einem der vorstehenden Ansprüche, umfassend von zu 45 bis 60 Gew.-% Acrylmonomer, vorzugsweise von zu 50 bis 60 Gew.-% Acrylmonomer; und/oder
wobei das Acrylmonomer umfasst
ein lineares Alkylacrylat umfasst, umfassend von 4 bis 12 Kohlenstoffatome, vorzugsweise von 6 bis 12 Kohlenstoffatome, mehr bevorzugt von 8 bis 10 Kohlenstoffatome; und/oder
wobei das Acrylmonomer umfasst
eines oder beide von 1,6-Hexandiol-diacrylat und 3-Methyl-1,5-pentandiol-diacrylat.

7. Zusammensetzung nach einem der vorstehenden Ansprüche, wobei das Acrylmonomer ein zyklisches Acrylat, vorzugsweise Tetrahydrofurfurylacrylat, zyklisches Trimethylolpropanformalacrylat, t-Butylcyclohexanolacrylat, 3,3,5-Trimethylcyclohexylacrylat, Isobornylacrylat und 2-Phenoxyethylacrylat, mehr bevorzugt Tetrahydrofurfurylacrylat, umfasst.

8. Zusammensetzung nach einem der vorstehenden Ansprüche, wobei der Photoinitiator umfasst:
einen Photoinitiator auf Alpha-Hydroxyketon-Basis, und/oder
einen Photoinitiator auf Phenylphosphinoxid-Basis, und/oder
einen Photoinitiator vom Ethylphenylglyoxylat-Typ;
vorzugsweise wobei der Photoinitiator umfasst:
einen Photoinitiator auf Alpha-Hydroxyketon-Basis,
einen Photoinitiator auf Phenylphosphinoxid-Basis, und
einen Photoinitiator vom Ethylphenylglyoxylat-Typ.

9. Zusammensetzung nach Anspruch 8, wobei der Photoinitiator auf Alpha-Hydroxyketon-Basis 2-Hydroxy-2-methyl-1-phenyl-propan-1-on umfasst; und/oder
wobei der Photoinitiator auf Phenylphosphinoxid-Basis Phenylbis(2,4,6-trimethylbenzoyl)-phosphinoxid, Ethyl-(2,4,6-trimethylbenzoyl)phenylphosphinat und/oder Diphenyl-(2,4,6-trimethylbenzoyl)phosphinoxid umfasst; und/oder
wobei der Photoinitiator vom Ethylphenylglyoxylat-Typ Methylbenzoylformiat umfasst; und/oder
wobei der Photoinitiator umfasst:
einen Initiator vom Thioxanthon-Typ, vorzugsweise umfassend 2-Isopropylthioxanthon; und
ein tertiärer Amin-Synergist, vorzugsweise umfassend Ethyl-4-(dimethylamino)benzoat.

10. Zusammensetzung nach einem der vorstehenden Ansprüche, umfassend von zu 3,8 bis 5,2 Gew.-% Photoinitiator, vorzugsweise von zu 4 bis 4,5 Gew.-% Photoinitiator.

11. Zusammensetzung nach einem der vorstehenden Ansprüche, wobei das Entschäumungsmittel ein Polyethersiloxan umfasst; und/oder
umfassend von zu 0,2 bis 0,8 Gew.-% Entschäumungsmittel, vorzugsweise von zu 0,3 bis 0,7 Gew.-% Entschäumungsmittel; und/oder
wobei das Dehydratisierungsmittel p-Toluolsulfonylisocyanat umfasst; und/oder
umfassend von zu 0,7 bis 1,3 Gew.-% Dehydratisierungsmittel, vorzugsweise von zu 0,8 bis 1,2 Gew.-% Dehydratisierungsmittel; und/oder
wobei das Benetzungsmittel Poly[dimethylsiloxan-co-methyl(3-hydroxypropyl)siloxan]-pfropf-poly(ethylenglycol)methylether umfasst; und/oder
umfassend von zu 0,5 bis 1,3 Gew.-% Benetzungsmittel, vorzugsweise von zu 0,8 bis 1,2 Gew.-% Benetzungsmittel.

12. Zusammensetzung nach einem der vorstehenden Ansprüche, umfassend zu 1 bis 2 Gew.-% Kopplungsmittel, vorzugsweise von zu 1,3 bis 1,8 Gew.-% Kopplungsmittel; und/oder
ferner umfassend einen Rheologiemodifikator, vorzugsweise wobei der Rheologiemodifikator Polyamidwachs umfasst und/oder wobei die Zusammensetzung von zu 0,1 bis 2,5 Gew.-% Rheologiemodifikator, vorzugsweise von zu 0,2 bis 0,8 Gew.-% Rheologiemodifikator, mehr bevorzugt von zu 0,3 bis 0,7 Gew.-% Rheologiemodifikator, umfasst.

13. Zusammensetzung nach einem der vorstehenden Ansprüche, ferner umfassend einen UV-Tracer, vorzugsweise wobei der UV-Tracer 2,5-Thiophendiylbis(5-tert-butyl-1,3-benzoxazol umfasst und/oder die Zusammensetzung von zu 0,1 bis 0,5 Gew.-% UV-Tracer, vorzugsweise von zu 0,2 bis 0,4 Gew.-% UV-Tracer, umfasst; und/oder
ferner umfassend ein Geruchsmaskierungsmittel; vorzugsweise wobei das Geruchsmaskierungsmittel eines oder beide von Dimethyloct-7-en-2-ol und Butylcyclohexylacetat, vorzugsweise beide, umfasst.

14. Verfahren zum konformen Beschichten eines Substrats, das Verfahren umfassend:
Bereitstellen eines Substrats, vorzugsweise wobei das Substrat eine Leiterplatte oder eine elektronische Komponente umfasst,
Bereitstellen der Zusammensetzung nach einem der vorstehenden Ansprüche,
Abscheiden der Zusammensetzung über mindestens einen Abschnitt des Substrats, und
Aussetzen des beschichteten Substrats einer aktinischen Strahlung.

15. Substrat, das mit der Zusammensetzung nach einem der Ansprüche 1 bis 13 beschichtet ist.

## Revendications

1. Composition de revêtement conforme durcissable aux UV et à l'humidité comprenant :
de 25 à 65 % en poids de polyuréthane acrylé fonctionnel à l'isocyanate,
de 30 à 65 % en poids de monomère acrylique,
de 3,5 à 5,5 % en poids de photoinitiateur,
de 0,1 à 1 % en poids d'agent antimousse,
de 0,5 à 1,5 % en poids d'agent de déshydratation,
de 0,2 à 1,5 % en poids d'agent mouillant, et
de 0,5 à 2,5 % en poids d'agent de couplage, dans laquelle l'agent de couplage comprend un silane fonctionnel acrylate et/ou un silane fonctionnel méthacrylate.

2. Composition selon la revendication 1, comprenant de 30 à 50 % en poids de polyuréthane acrylé fonctionnel à l'isocyanate, de préférence de 35 à 45 % en poids de polyuréthane acrylé fonctionnel à l'isocyanate ; et/ou
dans lequel le polyuréthane acrylé fonctionnel à l'isocyanate est un thermoplastique ; et/ou
dans lequel le polyuréthane acrylé fonctionnel à l'isocyanate est un élastomère.

3. Composition selon la revendication 1 ou la revendication 2, dans laquelle le polyuréthane acrylé fonctionnel à l'isocyanate présente un rapport de groupes fonctionnels d'acrylate à groupes fonctionnels d'isocyanate de 2:1 à 1:2.

4. Composition selon l'une quelconque revendication précédente, dans laquelle le polyuréthane acrylé fonctionnel à l'isocyanate est le produit de réaction de réactifs comprenant les espèces suivantes :
un polyol, de préférence un polyol hydrophobe amorphe ;
un diisocyanate, de préférence un diisocyanate à chaîne ramifiée ; et
un acrylate d'hydroxyalkyle ;
de préférence, dans lequel le polyol comprend :
un ou plusieurs parmi du polybutadiène hydroxyterminé, polybutadiène hydrogéné hydroxyterminé, polyisoprène hydroxyterminé, polyoléfines hydroxyterminées, polyfarnesène hydroxyterminé, polyfarnesène hydrogéné hydroxyterminé, huile de ricin, huile de ricin hydrogénée et polyols de polyester à base d'acide dimérique (de préférence C36), de préférence un ou plusieurs des produits suivants huile de ricin, huile de ricin hydrogénée et polyols de polyester à base d'acide dimère (de préférence C36), de préférence un ou plusieurs polybutadiène hydrogénés terminés par l'hydroxy, polyfarnesène hydrogéné terminé par l'hydroxy, huile de ricin hydrogénée et polyols de polyester à base d'acide dimère ; et/ou
des diols choisis parmi un ou plusieurs de 2-éthyl-1, 3-hexanediol, 1,4-butanediol, 3-méthyl-1, 5-pentanediol, 1,6-hexanediol, isosorbide, dimerdiol en C₁₈, 2-butyl-2-éthyl-1, 3-propanediol, 2,2-diméthyl-1, 3-propanediol et 2,2-diéthyl-1,3-propanediol, de préférence un ou plusieurs 2-éthyl-1, 3-hexanediol, dimerdiol en C₁₈ et 2-butyl-2-éthyl-1, 3-propanediol ; et/ou
des triols choisis parmi un ou plusieurs de triméthylolpropane, triéthanolamine, diéthanolamine, 1, 2, 6-hexanetriol, phloroglucinol (1, 3, 5-trihydroxybenzène) et glycérol, de préférence 1, 2, 6-hexanetriol.

5. Composition selon la revendication 4, dans laquelle le polyol a une masse molaire de 500 à 3 000 gmol⁻¹, de préférence de 1 000 à 2 000 gmol⁻¹, plus préférablement d'environ 2 000 gmol⁻¹; et/ou
dans laquelle le polyol a une fonctionnalité de 1,9 à 2,5 et/ou un indice d'hydroxyle de 50 à 250 mg KOH/g ; et/ou
dans laquelle le diisocyanate comprend un ou plusieurs parmi 1, 3-Bis(1-isocyanato-1-méthyléthyl)benzène (TMXDI, diisocyanate de tétraméthylxylène), 5-isocyanato-1-(isocyanatométhyl)-1, 3, 3-triméthylcyclohexane (IPDI, diisocyanate d'isophorone), 1, 6-diisocyanato-2, 2, 4 (2, 4, 4)-triméthylhexane (TMDI, Diisocyanate de triméthylhexaméthylène), 1, 6-diisocyanatohexane (HDI, diisocyanate d'hexaméthylène), 4, 4'-diisocyanatodicyclohexylméthane (H₁₂MDI) et 1, 5-diisocyanatopentane (PDI, 1, 5-pentaméthylènediisocyanate), de préférence 1, 6-diisocyanato-2, 2, 4 (2, 4, 4)-triméthylhexane (TMDI, Triméthylhexaméthylène diisocyanate) ; et/ou
dans laquelle l'acrylate d'hydroxyalkyle comprend un ou plusieurs des acrylates de 2-hydroxyéthyle, de 3-hydroxypropyle, de 4-hydroxybutyle, de méthacrylate de 2-hydroxyéthyle, de méthacrylate de 3-hydroxypropyle et de méthacrylate de 4-hydroxybutyle, de préférence l'acrylate de 4-hydroxybutyle.

6. Composition selon l'une quelconque revendication précédente, comprenant de 45 à 60 % en poids de monomère acrylique, de préférence de 50 à 60 % en poids de monomère acrylique ; et/ou
dans laquelle le monomère acrylique comprend
un acrylate d'alkyle linéaire comprenant de 4 à 12 atomes de carbone, de préférence de 6 à 12 atomes de carbone, plus préférablement de 8 à 10 atomes de carbone ; et/ou
dans laquelle le monomère acrylique comprend
un ou deux parmi du diacrylate de 1,6-hexane et diacrylate de 3-méthyl-1,5-pentanediol.

7. Composition selon l'une quelconque revendication précédente, dans laquelle le monomère acrylique comprend un acrylate cyclique, de préférence l'acrylate de tétrahydrofurfuryle, l'acrylate cyclique de triméthylolpropane formel, l'acrylate de t-butylcyclohexanol, l'acrylate de 3,3,5-triméthylcyclohexyle, l'acrylate d'isobornyle et l'acrylate de 2-phénoxyéthyle, plus préférablement l'acrylate de tétrahydrofurfuryle.

8. Composition selon l'une quelconque revendication précédente, dans laquelle le photoinitiateur comprend :
un photoinitiateur à base d'alpha-hydroxy-cétone, et/ou
un photoinitiateur à base d'oxyde de phénylphosphine, et/ou
un photoinitiateur de type phénylglyoxylate d'éthyle ;
de préférence, dans laquelle le photo-initiateur comprend :
un photoinitiateur à base d'alpha-hydroxy-cétone,
un photoinitiateur à base d'oxyde de phénylphosphine, et
un photoinitiateur de type phénylglyoxylate d'éthyle.

9. Composition selon la revendication 8, dans laquelle le photoinitiateur à base d'alpha-hydroxycétone comprend la 2-hydroxy-2-méthyl-1-phényl-propan-1-one ; et/ou
dans laquelle le photo-initiateur à base d'oxyde de phénylphosphine comprend l'oxyde de phényl-bis(2,4,6-triméthylbenzoyle)-phosphine, phosphinate d'éthyle (2,4,6-triméthylbenzoyle)phényle et/ou oxyde de diphényl (2,4,6-triméthylbenzoyle)-phosphine ; et/ou
dans laquelle le photoinitiateur de type phénylglyoxylate d'éthyle comprend du benzoylformate de méthyle ; et/ou
dans laquelle le photoinitiateur comprend :
un initiateur de type thioxanthone, de préférence comprenant du 2-isopropylthioxanthone ; et
un synergiste d'amine tertiaire, de préférence comprenant le benzoate d'éthyle-4-(diméthylamino).

10. Composition selon l'une quelconque revendication précédente, comprenant de 3,8 à 5,2 % en poids de photoinitiateur, de préférence de 4 à 4,5 % en poids de photoinitiateur.

11. Composition selon l'une quelconque revendication précédente, dans laquelle l'agent antimousse comprend un polyéther siloxane ; et/ou
comprenant de 0,2 à 0,8 % en poids d'agent antimousse, de préférence de 0,3 à 0,7 % en poids d'agent antimousse ; et/ou
dans laquelle l'agent de déshydratation comprend le p-toluènesulfonylisocyanate ; et/ou
comprenant de 0,7 à 1,3 % en poids d'agent de déshydratation, de préférence de 0,8 à 1,2 % en poids d'agent de déshydratation ; et/ou
dans laquelle l'agent mouillant comprend du poly[diméthylsiloxane-co-méthyl(3-hydroxypropyl)siloxane]-graft-poly(éthylène glycol) méthyl éther ; et/ou
comprenant de 0,5 à 1,3 % en poids d'agent mouillant, de préférence de 0,8 à 1,2 % en poids d'agent mouillant ;

12. Composition selon l'une quelconque revendication précédente, comprenant de 1 à 2 % en poids d'agent de couplage, de préférence de 1,3 à 1,8 % en poids d'agent de couplage ; et/ou
comprenant en outre un modificateur de rhéologie, de préférence dans lequel le modificateur de rhéologie comprend une cire de polyamide et/ou dans lequel la composition comprend de 0,1 à 2,5 % en poids de modificateur de rhéologie, de préférence de 0,2 à 0,8 % en poids de modificateur de rhéologie, plus préfablement de 0,3 à 0,7 % en poids de modificateur de rhéologie.

13. Composition selon l'une quelconque revendication précédente, comprenant en outre un traceur UV, de préférence, dans laquelle le traceur UV comprend du 2,5-thiophénediylbis(5-tert-butyl-1,3-benzoxazole et/ou la composition comprend de 0,1 à 0,5 % en poids de traceur UV, de préférence de 0,2 à 0,4 % en poids de traceur UV ; et/ou
comprenant en outre un agent masquant les odeurs ; de préférence, dans laquelle l'agent masquant les odeurs comprend un ou deux éléments parmi diméthyloct-7-en-2-ol et butylcyclohexylacétate, de préférence les deux.

14. Procédé de revêtement conforme d'un substrat, le procédé comprenant :
la fourniture d'un substrat, de préférence, dans lequel le substrat comprend une carte de circuit imprimé ou un composant électronique,
la fourniture de la composition selon l'une quelconque revendication précédente,
le dépôt de la composition sur au moins une partie du substrat, et
l'exposition du substrat revêtu à un rayonnement actinique.

15. Substrat revêtu avec la composition selon l'une quelconque des revendications 1 à 13.
